Europäisches Patentamt

European Patent Office

Office européen des brevets

(11) Publication number: **0 481 198 A2**

# EUROPEAN PATENT APPLICATION

(21) Application number: **91114385.7**

(22) Date of filing: **27.08.91**

(51) Int. Cl.5: **H01J 37/32**

(30) Priority: **16.10.90 US 598311**

(43) Date of publication of application:
**22.04.92 Bulletin 92/17**

(84) Designated Contracting States:
**DE FR GB**

(71) Applicant: **International Business Machines Corporation**
**Old Orchard Road**
**Armonk, N.Y. 10504(US)**

(72) Inventor: **Forster, John Curt**
**11 Maloney Road**
**Poughkeepsie, New York 12603(US)**
Inventor: **Holber, William Martin**
**255 West 98th Street**
**New York, New York 10025(US)**
Inventor: **Logan, Joseph Skinner**
**14 Highpoint Drive**
**Poughkeepsie, New York 12603(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

(54) **Scanned electron cyclotron resonance plasma source.**

(57) Electron cyclotron apparatus is described in which the locus of cyclotron resonance is scanned away from and toward the axis of a magnetic field by varying the strength of the magnetic field, the frequency of electromagnetic waves passing along its axis, or both.

**FIG. 1**

In the manufacture of solid state circuits and devices, it is often necessary to etch or deposit onto material that is exposed through openings in a mask. Whereas etching can be done by using chemical solutions, the spaces between the edges of adjacent openings have to be large enough to allow for the fact that material under the edges is undesirably removed, a phenomenon known as undercutting. This may be avoided by exposing the material in the openings of the mask to ions that are in a plasma derived by a phenomenon known as electron cyclotron resonance, ECR.

The ECR process can also be used with advantage in depositing metals, dielectrics and other substances on material exposed by the openings in a mask. In the ECR process, gas that will produce the desired ion or ions is introduced into a region of a chamber in which electromagnetic waves are propagated along the axis of a D.C. magnetic field. Any free electrons having some motion component perpendicular to the lines of flux of the field will tend to move in a circular path at a frequency determined by the strength of the magnetic field. If the electromagnetic waves have the same frequency, they impart energy to the electrons so as to cause them to dislodge electrons from atoms in the gas and form ions. Once started, the process is accumulative so as to increase the number of ions until a steady state is reached in which the number of electrons equals the number of ions and the ion generation rate equals the ion loss rate.

The electrons move along the lines of magnetic flux in a direction of the weaker field. By virtue of the electrostatic field thus created, ions tend to be pulled along the same direction.

A major problem with the ECR process is that there may be a spatial variation in the density of the ions arriving at the mask. Thus, for example, if corresponding parts of different devices are respectively exposed through openings in the mask, the amount of etching or deposition at different openings is different so that the devices may have different electrical characteristics.

This nonuniformity arises from the fact that the density with which ions are produced depends both on the intensity of the microwave illumination and on the degree to which the strength of the magnetic field approaches the optimum value required for resonance and the fact that neither is uniform across the plasma source region. Since the electrons and ions tend to follow magnetic flux lines from the source region to the substrate at which etching or deposition is to take place, the nonuniformity of the plasma across the source will be imaged onto the substrate.

One previous method for reducing the degree of nonuniformity in the flux of ions arriving at the substrate has been to use a smaller cross section source in which the microwave modes are carefully controlled. Among other problems, however, the smaller cross-section tends to reduce the ion flux at the substrate to a smaller value.

A second approach that is described in an article entitled "A Parametric Study of the Etching of Silicon in $SF_6$ Microwave Multipolar Plasmas: Interpretation of Etching Mechanisms" published at pages 825-834 of the June, 1987 issue of the Japanese Journal of Applied Physics, 26(G), operates without an axial magnetic field guiding the plasma from the source region to the substrate. Instead, a secondary cusp-type magnetic field, typically created using an array of permanent magnets bounding the drift tube connecting the source region and the substrate, aids radial confinement of the plasma and allows some mixing of radial nonuniformities of the plasma.

As previously noted, the most dense production of ions takes place in regions where the intensity of the microwave electromagnetic field is high and where the strength of the magnetic field is such that the electrons orbit at the frequency of the microwave electromagnetic field. As a lower density occurs at other points, the density of ions produced in a cross section is not uniform.

In accordance with this invention as claimed, the location of the region at which resonance occurs is changed or scanned across the magnetic field in a cyclic manner so that the time averaged density of ions produced in all parts of the cross section of the field is nearly the same. This scanning of the region at which resonance occurs may be accomplished in accordance with this invention in the following ways.

If the magnetic field is symmetric about the axis and increases in strength with distance from the axis, then the resonance along a cross-section of the magnetic field perpendicular to the lines of flux and to the axis of the machine will take place along a circular locus centered about the axis. If the strength of the magnetic field is increased, resonance will occur along a smaller circular locus. Resonance along this latter locus could also be attained by decreasing the frequency of the electromagnetic waves. Therefore, the radius of the circular locus along which resonance occurs can be radially scanned from zero to a maximum value and back to zero by changing the strength of the magnetic field, the frequency of the electromagnetic waves or both. If, for example, it takes one minute for the number of ions to be produced that are required for an etching or deposition process step, a scanning cycle of two seconds would permit thirty cycles to be made so that the time averaged density of ions arriving at all parts of the mask would be nearly uniform.

For a better understanding of the present invention, together with further objects and advantages, a preferred embodiment of the invention is described in the following with reference to the accompanying drawings, in which:

Fig. 1 is a schematic diagram of ECR apparatus incorporating this invention,

Fig. 2 illustrates an example of magnetic field strength occurring at different axial locations,

Fig. 3 is a graph showing the linear relationship between magnetic field strength and the frequency of the electromagnetic waves at resonance,

Fig. 4 is a plot of the magnetic field strength in Gauss in a radial plane as a function of radial distance from the center or axis of a cylindrical magnetic field and shows the radius at which resonance occurs when the frequencies of the electromagnetic waves is 2.45 GHz,

Fig. 4A shows the location of the resonance indicated in Fig. 3 when viewed along the axis,

Fig. 5 is a plot of magnetic field strengths in a radial plane in Gauss as a function of radial distance from the center or axis of a cylindrical magnetic field and shows the radii at which resonance occurs when the frequencies of the electromagnetic waves are 2.10 GHz and 2.45 GHz, and,

Fig. 5A shows the location of the resonance indicated in Fig. 5 when viewed along the axis.

Reference is now made to the schematic representation of electron cyclotron resonance apparatus constructed in accordance with this invention for use in etching material from a substrate or for depositing material on it.

A metal chamber generally indicated at 2 has a cylindrical section 4 in which a substrate 6 to be processed and a mask 7 superimposed thereon are mounted in some suitable manner such as resting them on radial fingers 8 and 10, a cylindrical resonance section 12 made of quartz, or other suitable dielectric material, in which a plasma is formed by resonance action on gas entering the cavity 12 via a port 14, and a cylindrical section 16 at the other end to which a vacuum pump 18 may be coupled via a duct 20. This diagram is exemplary, it is contemplated, for example, that the vacuum pump 18 may be coupled to other points in the structure. If desired, a gas port 22 can be provided in the cylindrical section 4 at a point that is axially between the substrate 6 and the cylindrical resonance section 12. For example, if $SiO_2$ is to be deposited on the substrate 6, oxygen is passed through the port 14 and silane, $SiH_4$, is passed through the port 22.

Coils 24, 26 and 28 that are wound about the axis A of the cavity section 12 produce a magnetic field, a portion of which is represented by flux lines 30 that pass in a generally axial direction through the cylindrical sections 12 and 4. The coils 24, 26 and 28 are respectively powered by current supplies 32, 34 and 36 under the control of a microprocessor 38. The strength of the magnetic field decreases in a downward direction along the axis A and increases with radius within the resonance region from any point on the axis.

A source 40 of microwaves, which may be a klystron or a magnetron, directs a beam of electromagnetic waves along a waveguide 42 to a cavity section 44 that is joined to the cylindrical section 4 and which surrounds the resonance section 12. The waves enter the resonance section 12 via a vacuum window 46. In some implementations, the vacuum window and the cylindrical resonance are a single unit made of quartz or other suitable dielectric material. The frequency and amplitude of the electromagnetic waves are controlled by the processor 38.

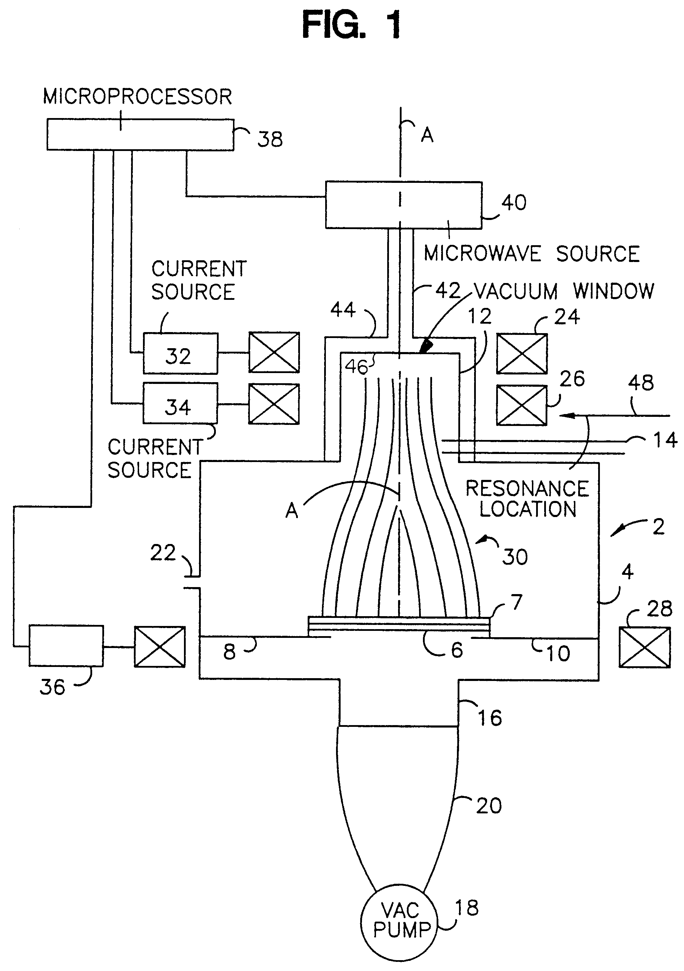

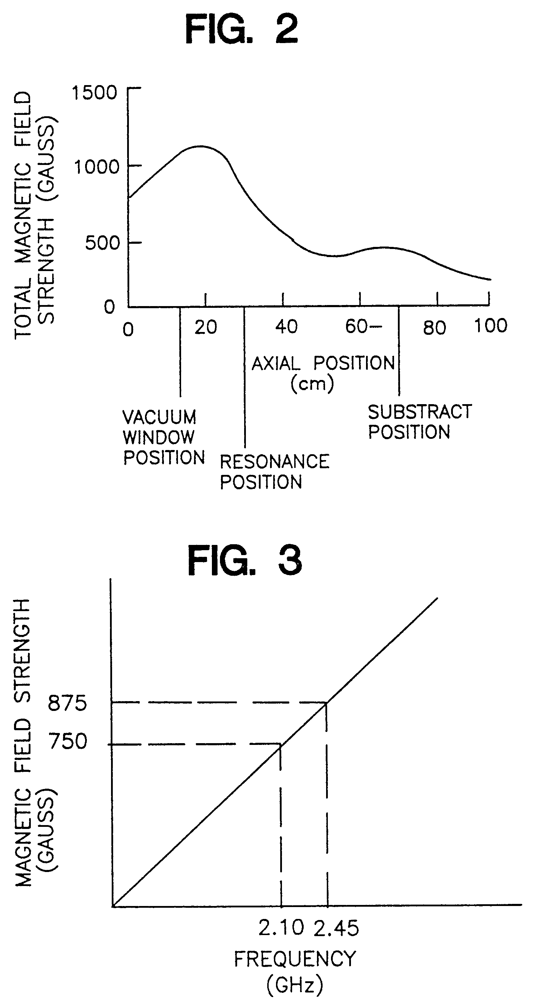

Fig. 2 illustrates a calculated line of magnetic field strength at various axial positions along the axis A that result from the action of the coils 24, 26 and 28 including the axial positions at the vacuum window 46, a radial plane 48 at which resonance occurs and the substrate 6. Note that in Fig. 1 the lines of field strength of the magnetic field are perpendicular to the substrate 6.

Fig. 3 is a graph of the magnetic field strength resulting from the action of the coils 24, 26 and 28 versus the frequency of the electromagnetic waves. This graph shows a locus of points at which resonance occurs. From Fig. 3, it is seen that, at a frequency of 2.1 GHz, resonance occures when the magnetic field strength is approximately 750 Gauss and, at a frequency of 2.45 GHz, resonance occurs when the magnetic field strength is approximately 875 Gauss.

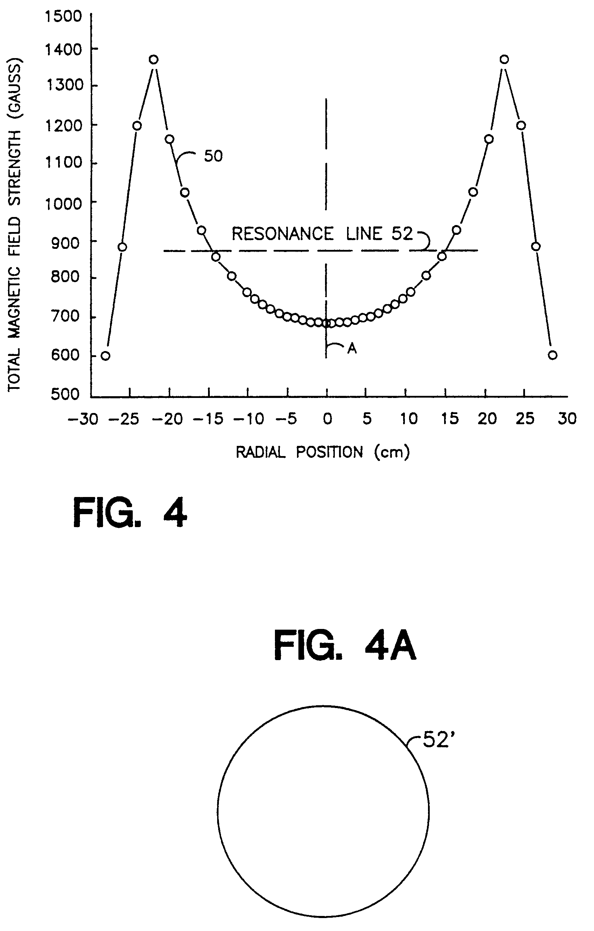

A curve 50 in Fig. 4 illustrates the variation in the strength of the magnetic field with radial distance from the axis A when a particular set of coils 24, 26 and 28 are used in Fig. 1. With the electromagnetic waves having a frequency of 2.45 GHz, resonance occurs at 875 Gauss as indicated at the intersections of a dashed resonance line 52 with the curve 50. Since, in this example, the field strength is symmetrical about the axis A, and the intensity of the electromagnetic illumination is assumed to be uniform, the locus or region of the maximum resonance, when viewed along the axis A, is a circle 52' as shown in Fig. 4A.

The entire curve 50 can be moved up or down as indicated by the arrows so as to change the radius of the locus at which resonance and maximum plasma density occur, and hence the radius of the circle 52', by simply changing the magnitudes of the currents flowing in the coils 24, 26 and 28. A suitable cyclic variation of the currents respectively supplied by the current sources 32, 34 and 36 to the solenoid coils 24, 26 and 28 can be controlled by the processor 38.

As the radius of the circle 52 at which maximum resonance occurs varies, the locus at which a maximum density of ions arriving at the mask varies in like manner, so that the maximum density of ions is radially scanned back and forth across the mask 7.

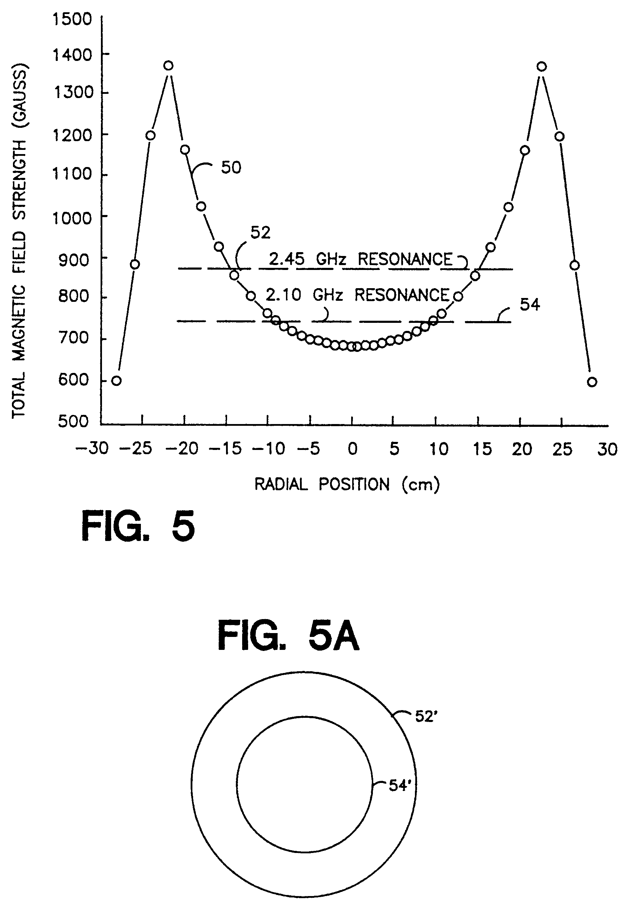

Radial scanning of the locus or region of maximum ion density can also be achieved by varying the frequency of the electromagnetic waves emanating from the source 40 under the control of the processor 38. Figs 5 and 5A are respectively the same as Figs. 4 and 4A except for the addition of a dashed resonance line 54 in Fig. 5 and a corresponding circular locus 54' in Fig. 5A. The curve 50 of magnetic field strength remains the same and the dashed line at which resonance occurs moves up and down it as the frequency of the electromagnetic waves is varied. At frequencies of 2.45 GHz and 2.10 GHz, resonance respectively occurs at the loci 52' and 54'.

It is readily apparent to one skilled in the art that radial scanning of the locus of electron cyclotron resonance could be attained by varying both the magnetic field strength and the frequency of the electromagnetic waves.

It is to be understood that propagation of the electromagnetic waves along the axis of the magnetic field includes propagation along a slight angle thereto. Those skilled in the art are aware of the fact that maximum density of plasma may occur in some circumstances when the propagation is precisely along the axis and that it may fall off as the angle between the direction of propagation and the axis increases.

## Claims

1. Electron cyclotron resonance apparatus comprising:

   a chamber (2),

   means (32, 34; 36; 24, 26, 28) for producing an axial magnetic field in said chamber that varies in strength with radius from the axis and decreases in strength in a given direction along the axis,

   means (40) for passing electromagnetic waves into said magnetic field,

   means (14, 22) defining at least one opening in said chamber through which gas can be passed to a region occupied by said magnetic field and said electromagnetic waves, and

   scanning means for varying at least one of the strength of the magnetic field and the frequency of said electromagnetic waves so as to change the locus along which maximum cyclotron resonance occurs.

2. Electron cyclotron resonance apparatus as set forth in Claim 1 wherein:

   the electromagnetic waves are propagated along the said axis.

3. Electron cyclotron resonance apparatus as set forth in Claim 1 or 2 further comprising:

   means (8, 10) for supporting a substrate (6) in said chamber at a point along the axis, and

   means for producing a collimating magnetic field having flux perpendicular to a substrate when mounted on said means for supporting it.

4. Electron cyclotron apparatus as set forth in Claim 1, 2 or 3 further comprising:

   a port (14, 22) in said chamber located at a point between the locus of resonance and said supports whereby gas may be introduced.

5. A method of producing a flow of ions to a substrate comprising the steps of:

   forming a D.C. magnetic field with an axis,

   projecting a beam of electromagnetic waves along the axis toward a substrate, and

   cyclically varying at least one of the strength of the magnetic field and the frequency of the electromagnetic waves so as to cause the time averaged densities of ions arriving at different parts of the substrate to approach the same value.

6. A method as set forth in claim 5 wherein the strength of the magnetic field and the frequency of the electromagnetic waves are both cyclically varied.

7. Electron cyclotron resonance apparatus for producing a flow of ions toward a substrate (6) comprising:

means (32, 34, 36; 24, 26, 28) for producing a D.C. magnetic field having an axis,

means (40) for projecting electromagnetic waves along said axis,

means (8, 10) for mounting a substrate (6) in the magnetic field transversely to said axis, and

means for varying said magnetic field in magnitude so as to make the densities of the ions arriving at different parts of said substrate more nearly the same.

8. Electron cyclotron resonance apparatus according to claim 7, additionally comprising:

means for varying said electromagnetic waves in frequency.

9. Electron cyclotron resonance apparatus according to claim 8, further comprising:

means for cyclically varying the frequency of the electromagnetic waves.

10. Electron cyclotron resonance apparatus according to claim 7, 8 or 9, further comprising:

means for cyclically varying the magnitude of the magnetic field.

# FIG. 1

MICROPROCESSOR

38

A

40

MICROWAVE SOURCE

CURRENT SOURCE

32

34

CURRENT SOURCE

44

42 VACUUM WINDOW

12

24

26

48

14

46

22

A

RESONANCE LOCATION

30

2

4

7

8

6

10

28

36

16

20

VAC PUMP

18

# FIG. 2

# FIG. 3

FIG. 4

FIG. 4A

FIG. 5

FIG. 5A